# EUROPEAN PATENT APPLICATION

(11) **EP 4 770 335 A1**
(43) Date of publication of application: **01.07.2026**
(21) Application number: 25224597.2
(22) Date of filing: 17.12.2025
(51) Int. Cl.: H10D 86/40, H10D 86/60, H10K 59/121, H10K 59/131

(54) **DISPLAY DEVICE**

(30) Priority: 31.12.2024 KR 20240202265
(71) Applicant: LG Display Co., Ltd., Seoul, 07336 (KR)
(72) Inventor: KIM, JiAh, 10845 Paju-si (KR); KIM, JuHan, 10845 Paju-si (KR); KIM, KaKyung, 10845 Paju-si (KR)
(74) Representative: Morrall, Jonathan Ian McLachlan

(57) **Abstract**

A display device includes a substrate including a plurality of sub-pixels, a first buffer layer disposed on the substrate, a plurality of first signal lines disposed on the first buffer layer, a second buffer layer disposed on the plurality of first signal lines, a first transistor disposed on the second buffer layer and electrically connected to one of the plurality of first signal lines, a third buffer layer disposed on the first transistor, and a second transistor disposed on the third buffer layer.

## Description

### CROSS-REFERENCE TO RELATED APPLICATIONS

This application claims the priority of and benefits to Korean Patent Application No. 10-2024-0202265 filed on December 31, 2024, in the Korean Intellectual Property Office, the disclosure of which is incorporated herein by reference in its entirety for all purposes, as if fully set forth herein.

### TECHNICAL FIELD

The present disclosure relates to a display device.

### BACKGROUND

The field of display devices that visually display electrical information signals is rapidly developing, and research is being conducted to improve performances such as thinning, weight reduction, and low power consumption for various display devices.

Examples of representative display devices include a liquid crystal display (LCD), a field emission display (FED), an electro-wetting display (EWD), and an organic light emitting display (OLED). An electroluminescent display device represented by an organic light emitting display device is a self-emitting display device and does not require a separate light source unlike a liquid crystal display device. Therefore, the electroluminescent display device can be manufactured to have a light weight and a small thickness.

The description provided in the background section should not be assumed to be prior art merely because it is mentioned in or associated with the background section. The background section may include information that describes one or more aspects of the subject technology.

### SUMMARY

In order to provide a high-resolution image while reducing or minimizing the design area in the display device, transistors constituting the sub-pixel circuit may be disposed in multiple layers. However, in the display device, when the signal line of the sub-pixel circuit is disposed on the substrate relatively in the upper layer, it is inevitable to design a contact hole of the signal line from the top to the bottom, so that other components may not be designed to overlap in the lower region of the signal line.

An object to be achieved by the present disclosure is to provide a display device in which the degree of freedom in design is improved when a plurality of transistors is implemented in multiple layers in a sub-pixel circuit.

Objects of the present disclosure are not limited to the above-mentioned objects, and other objects, which are not mentioned above, can be clearly understood by those skilled in the art from the following description.

A display device according to an exemplary embodiment of the present disclosure includes: a substrate including a plurality of sub-pixels; a first buffer layer disposed on the substrate; a plurality of first signal lines disposed on the first buffer layer; a second buffer layer disposed on the plurality of first signal lines; a first transistor disposed on the second buffer layer and electrically connected to one of the plurality of first signal lines; a third buffer layer disposed on the first transistor; and a second transistor disposed on the third buffer layer.

A display device according to another embodiment of the present specification includes: a substrate including a plurality of sub-pixels; a light emitting element included in each of the plurality of sub-pixels; a plurality of first signal lines disposed on the substrate and including a data line which supplies a data voltage and a high potential power line which supplies a high potential power voltage; a plurality of sub-pixel circuits disposed in each of the plurality of sub-pixels on the substrate and electrically connected to the plurality of first signal lines; a first transistor including a first electrode connected to the high potential power line, a gate electrode to which an emission signal is input, and a second electrode connected to a first node; and a second transistor including a first electrode connected to a second node, a gate electrode to which a scan signal is input, and a second electrode connected to the data line, wherein the plurality of first signal lines is disposed under the first transistor and the second transistor.

Other detailed matters of the embodiments are included in the detailed description and the drawings.

According to the present disclosure, the plurality of signal lines is disposed on the lowermost layer on the substrate, such that transistors may be disposed in a multiple layers on the plurality of signal lines, thereby increasing the degree of design freedom.

Further, according to the present disclosure, it is possible to implement a high-resolution image and also possible to reduce a design area without a large change in the arrangement of components of the sub-pixel circuit.

The effects according to the present disclosure are not limited to the contents exemplified above, and more various effects are included in the present disclosure.

It is to be understood that both the foregoing general description and the following detailed description are exemplary and explanatory and are intended to provide further explanation of the inventive concepts as claimed.

### BRIEF DESCRIPTION OF DRAWINGS

The accompanying drawings, which are included to provide a further understanding of the disclosure and are incorporated in and constitute a part of this application, illustrate embodiments of the disclosure and together with the description serve to explain the principle of the disclosure. The above and other aspects, features and other advantages of the present disclosure will be more clearly understood from the following detailed description taken in conjunction with the accompanying drawings, in which:
FIG. 1 is a block diagram of a display device according to an exemplary embodiment of the present disclosure.
FIG. 2 is a sub-pixel circuit diagram of a display device according to an exemplary embodiment of the present disclosure.
FIGS. 3A to 3G are schematic enlarged top plan views of a region of a display area of a display device according to an exemplary embodiment of the present disclosure.
FIG. 3H is an enlarged plan view of the display area of the display device according to an exemplary embodiment of the present disclosure.
FIG. 4 is a cross-sectional view of a sub-pixel of the display device according to the embodiment of the present disclosure.
FIG. 5 is a cross-sectional view for explaining an example of a structure in which a metal pattern of the display device according to an exemplary embodiment of the present disclosure is in contact with an active layer of the display device.
FIG. 6 is a cross-sectional view for explaining another example of a structure in which a metal pattern of the display device according to an exemplary embodiment of the present disclosure is in contact with an active layer of the display device.
Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION OF THE EMBODIMENT

Reference will now be made in detail to embodiments of the present disclosure, examples of which may be illustrated in the accompanying drawings. The progression of processing steps and/or operations described is an example; however, the sequence of steps and/or operations is not limited to that set forth herein and may be changed as is known in the art, with the exception of steps and/or operations necessarily occurring in a particular order. Names of the respective elements used in the following explanations may be selected only for convenience of writing the specification and may be thus different from those used in actual products.

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. **The** exemplary embodiments are provided by way of example only so that those skilled in the art can fully understand the disclosures of the present disclosure and the scope of the present disclosure.

**The** shapes (e.g., sizes, lengths, widths, heights, thicknesses, locations, radii, diameters, and areas), ratios, angles, numbers, and the like illustrated in the accompanying drawings for describing the exemplary embodiments of the present disclosure are merely examples, and the present disclosure is not limited thereto. Further, in the following description of the present disclosure, a detailed explanation of known related technologies may be omitted to avoid unnecessarily obscuring the subject matter of the present disclosure. **The** terms such as "including," "having," and "consist of" used herein are generally intended to allow other components to be added unless the terms are used with the term "only". Any references to singular may include plural unless expressly stated otherwise.

**The** word "exemplary" is used to mean serving as an example or illustration. Aspects are example aspects. "Embodiments," "examples," "aspects," and the like should not be construed as preferred or advantageous over other implementations. An embodiment, an example, an example embodiment, an aspect, or the like may refer to one or more embodiments, one or more examples, one or more example embodiments, one or more aspects, or the like, unless stated otherwise. Further, the term "may" encompasses all the meanings of the term "can."

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

In describing a time relationship, for example, when the temporal order is described as, for example, "after," "subsequent," "next," and "before," a case which is not continuous may be included unless a more limiting term, such as "just," "immediate(ly)," or "direct(ly)" is used.

**The** terms, such as "below," "lower," "above," "upper" and the like, may be used herein to describe a relationship between element(s) as illustrated in the drawings. It will be understood that the terms are spatially relative and based on the orientation depicted in the drawings.

When an element or layer is disposed "on" another element or layer, another layer or another element may be interposed directly on the other element or therebetween.

Although the terms "first", "second", "A," "B," "(a)," and "(b)" and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the disclosure.

A size and a thickness of each component illustrated in the drawing are illustrated for convenience of description, and the present disclosure is not limited to the size and the thickness of the component illustrated.

The term "at least one" should be understood as including any and all combinations of one or more of the associated listed items. For example, the meaning of "at least one of a first element, a second element, and a third element" compasses the combination of all three listed elements, combinations of any two of the three elements, as well as each individual element, the first element, the second element, or the third element.

The features of various embodiments of the present disclosure can be partially or entirely adhered to or combined with each other and can be interlocked and operated in technically various ways, and the embodiments can be carried out independently of or in association with each other.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

Hereinafter, exemplary embodiments of the present disclosure will be described in detail with reference to accompanying drawings.

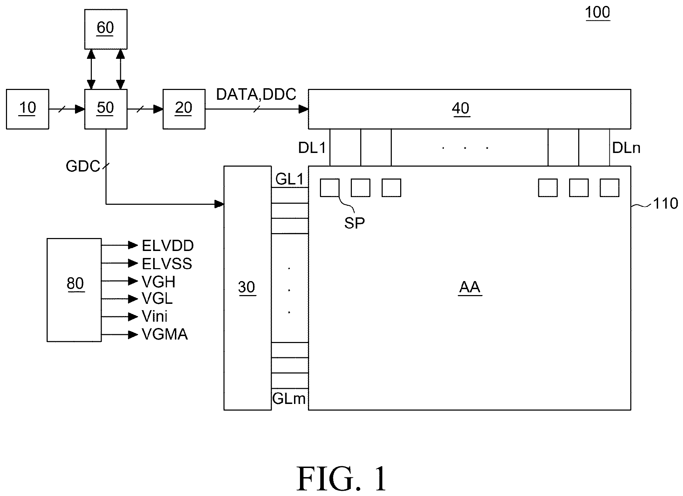

FIG. 1 is a block diagram of a display device according to an exemplary embodiment of the present disclosure.

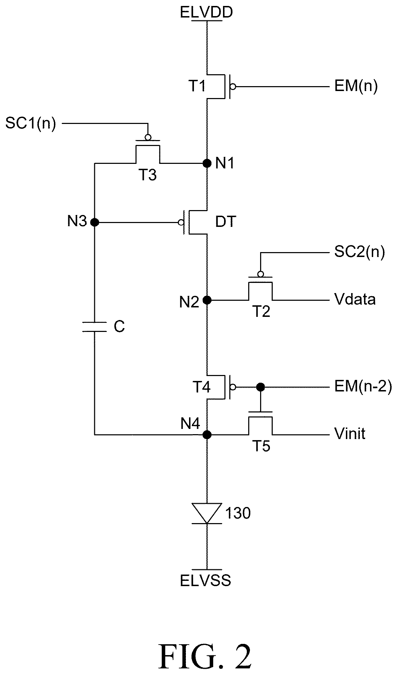

FIG. 2 is a sub-pixel circuit diagram of the display device according to an exemplary embodiment of the present disclosure.

Referring to FIG. 1, a display device 100 according to embodiments of the present disclosure may include a display panel 110, an image processor 10 that transmit signals to the display panel 110, a degradation compensator 50, a memory 60, a timing controller 20, a gate driver 30, a data driver 40, and a power supply unit 80. Embodiments are not limited thereto. As an example, at least one or more of the above-mentioned components may be omitted depending on the design. As an example, at least one or more additional components may be further included, without being limited thereto.

The image processor 10 outputs driving signals for driving various devices in addition to image data supplied from the outside. For example, the driving signal may include a data enable signal, a vertical synchronization signal, a horizontal synchronization signal, and a clock signal, without being limited thereto.

The timing controller 20 may receive a driving signal output from the image processor 10 and image data modulated by the degradation compensator 50. The timing controller 20 may generate and output a gate timing control signal GDC for controlling operation timing of the gate driver 30 and a data timing control signal DDC for controlling operation timing of the data driver 40 based on the driving signal input from the image processor 10. The timing controller 20 may control operation timings of the gate driver 30 and the data driver 40 to obtain at least one sensing voltage from each sub-pixel SP and supply the sensing voltage to the degradation compensator 50.

The gate driver 30 may output the scan signal to the display panel 110 in response to the gate timing control signal GDC supplied from the timing controller 20. The gate driver 30 may output a scan signal and an emission signal through a plurality of gate lines GL1 to GLm.

The gate driver 30 may be formed as an integrated circuit (IC), but is not limited thereto. The gate driver 30 may be formed in a gate-in-panel (GIP) structure formed by directly stacking thin film transistors on a substrate of the display device 100. The GIP structure may include a plurality of circuits such as a shift register and a level shifter. Embodiments are not limited thereto. As an example, the gate driver 30 may be separately disposed in a separate panel or film, and connected to the display panel 110, for example, in a tape automated bonding (TAB) method, a chip on glass (COG) method, a chip on panel (COP) method, or a chip on film (COF) method, without being limited thereto.

The data driver 40 may output a data voltage to the display panel 110 in response to the data timing control signal DDC input from the timing controller 20. The data driver 40 may sample and latch the digital data signal DATA supplied from the timing controller 20 to convert the same into an analog data voltage based on a gamma voltage. The data driver 40 may output a data voltage through a plurality of data lines DL1 to DLn. The data driver 40 may supply a sensing voltage input from the display panel 110 to the degradation compensator 50, without being limited thereto. The data driver 40 may be mounted on the display panel 110 in the form of an integrated circuit (IC) and may be formed by directly stacking together with various patterns on the display panel 110, but is not limited thereto. As an example, the data driver 40 may be separately disposed in a separate panel or film, and connected to the display panel 110, for example, in a tape automated bonding (TAB) method, a chip on glass (COG) method, a chip on panel (COP) method, or a chip on film (COF) method, without being limited thereto.

The degradation compensator 50 may calculate a degradation compensation gain value of the sub-pixel SP of the display panel 110 based on a sensing voltage supplied from the data driver 40, calculate a dimming weight value based on the calculated degradation compensation gain value, modulate input image data of each sub-pixel SP of the current frame based on the calculated degradation compensation gain value and the dimming weight value, and then supply the modulated image data to the timing controller 20. As an example, the degradation compensator 50 may be omitted depending on the design.

In the memory 60, a lookup table for the deterioration compensation gain value and a deterioration compensation time point for an emission layer of the sub-pixel SP may be stored. The deterioration compensation time point of the emission layer may be the number of driving operations or a driving time of a light emitting element.

The power supply unit 80 may supply a high potential power voltage ELVDD, a low potential power voltage ELVSS, and the like to the display panel 110. The high potential power voltage ELVDD and the low potential power voltage ELVSS may be supplied to the display panel 110 through the high potential power line and the low potential power line, respectively.

The voltage output from the power supply unit 80 may be output to the gate driver 30 or the data driver 40 and used for their driving. The power supply unit 80 may output a gate high voltage VGH, a gate low voltage VGL, an initialization voltage Vini, and the like. The gate high voltage VGH and the gate low voltage VGL are supplied to the gate driver 30, and constant voltages, such as the high potential power voltage ELVDD, the low potential power voltage ELVSS, and the initialization voltage Vini, are supplied to the sub-pixel SP through power lines commonly connected to the sub-pixel SP. Further, the power supply unit 80 may supply a gamma reference voltage VGMA to the data driver 40. The dynamic range of the data voltage output from the data driver 40 is a voltage range between the highest gray voltage and the lowest gray voltage, and is determined according to the voltage range of the gamma reference voltage VGMA.

Referring to FIG. 2, a sub-pixel SP of a display device 100 according to an exemplary embodiment of the present disclosure includes a light emitting element 130 and a sub-pixel circuit for driving the light emitting element 130.

The sub-pixel circuit may include a driving transistor DT, a plurality of switching transistors T1 to T5, and a storage capacitor C. Further, the sub-pixel circuit is connected to a plurality of signal lines including a data line to which a data voltage Vdata is applied, gate lines to which scan signals SC1(n) and SC2(n) are applied, and emission signal lines to which emission signals EM(n) and EM(n-2) are applied, a high potential power line to which the high potential power voltage ELVDD is applied, a low potential power line to which the low potential power voltage ELVSS is applied, and an initialization signal line to which the initialization voltage Vini is applied. As an example, signal lines for supplying a voltage on the display panel 110 may be commonly connected to all sub-pixels SP, without being limited thereto. For example, among the gate lines, a line to which scan signals SC1(n) and SC2(n) are applied may be referred to as a scan line, and a line to which emission signals EM(n) and EM(n-2) are applied may be referred to as an emission signal line.

The scan signal and the emission signal may swing between a gate-on voltage and a gate-off voltage. For example, the transistor is turned on in response to the gate-on voltage, while turned off in response to the gate-off voltage. In the case of the n-channel transistor, the gate-on voltage may be a gate high voltage VGH, and the gate-off voltage may be a gate low voltage VGL. In the case of the p-channel transistor, the gate-on voltage may be the gate low voltage VGL, and the gate-off voltage may be the gate high voltage VGH.

The base voltage level of the high potential power voltage ELVDD is higher than the maximum voltage of the data voltage Vdata and is set to a voltage at which the driving transistor DT may operate in a saturation region. The initialization voltage Vini may be set to a voltage lower than the high potential power voltage ELVDD and higher than the low potential power voltage ELVSS. The gate high voltage VGH may be set to be a voltage higher than the high potential power voltage ELVDD, and the gate low voltage VGL may be set to be a voltage lower than the low potential power voltage ELVSS, without being limited thereto. For example, the constant voltage applied to the sub-pixel circuit may be set to ELVDD=+8[V], Vini=+1.3[V], ELVSS=0[V], VGH=+12.5[V], VGL=-5[V], or the like, but is not limited thereto.

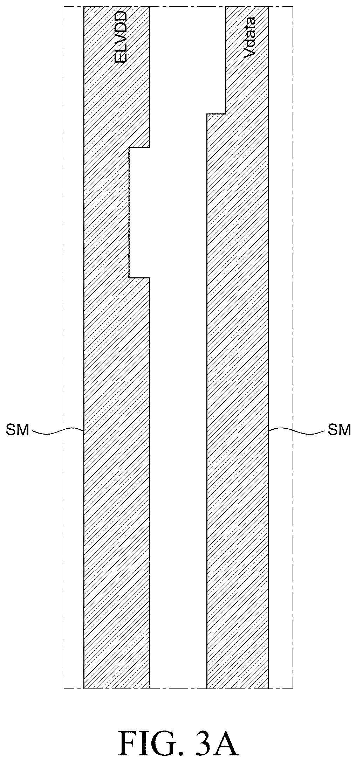

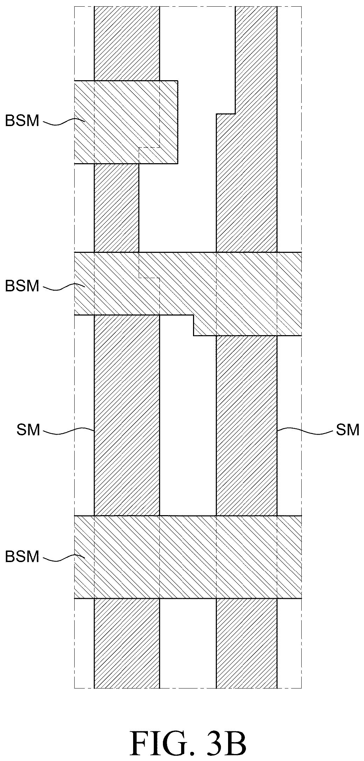

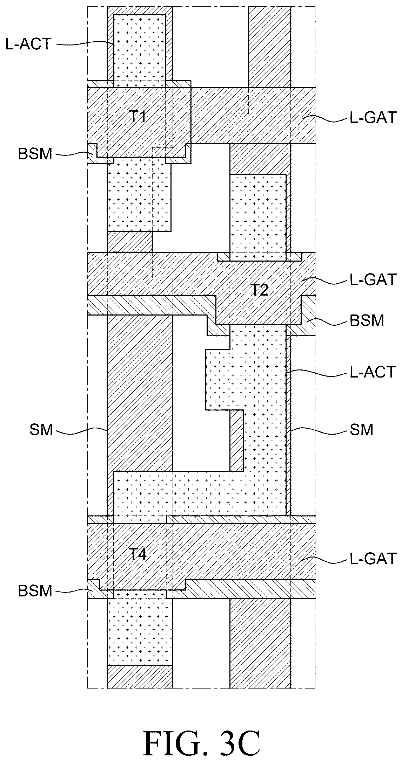

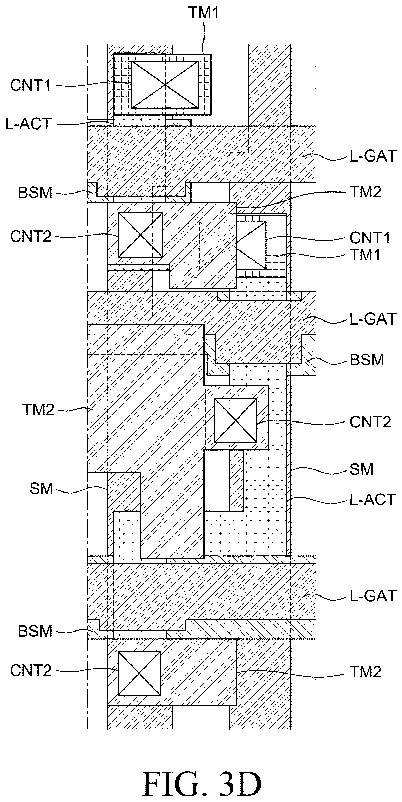

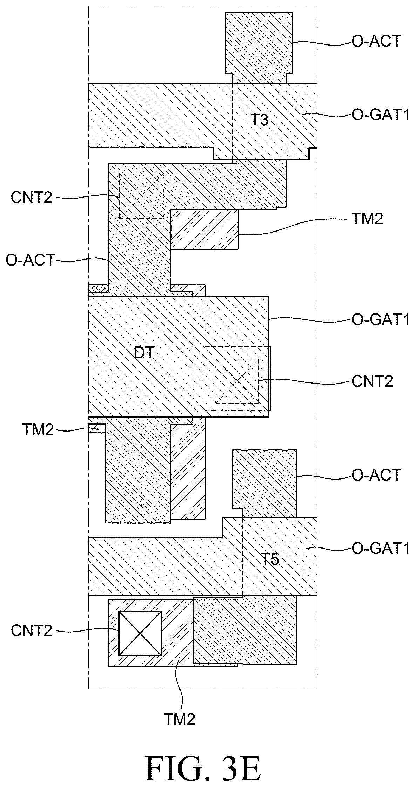

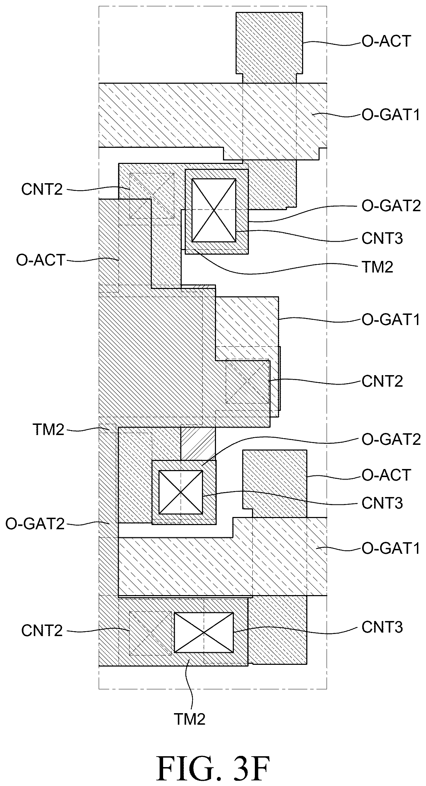

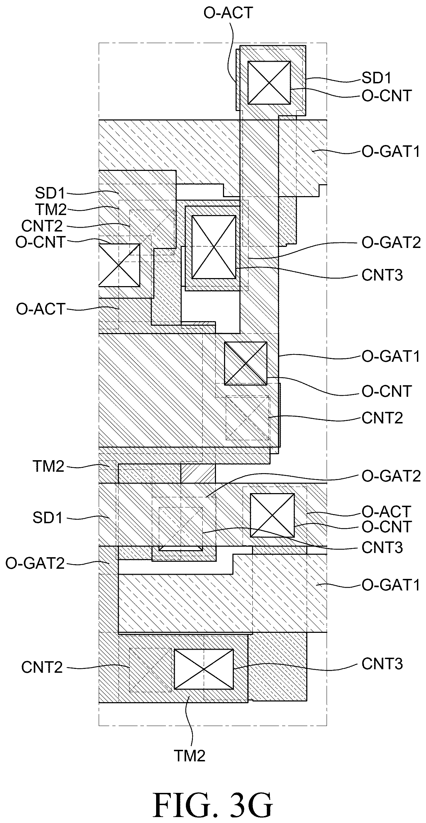

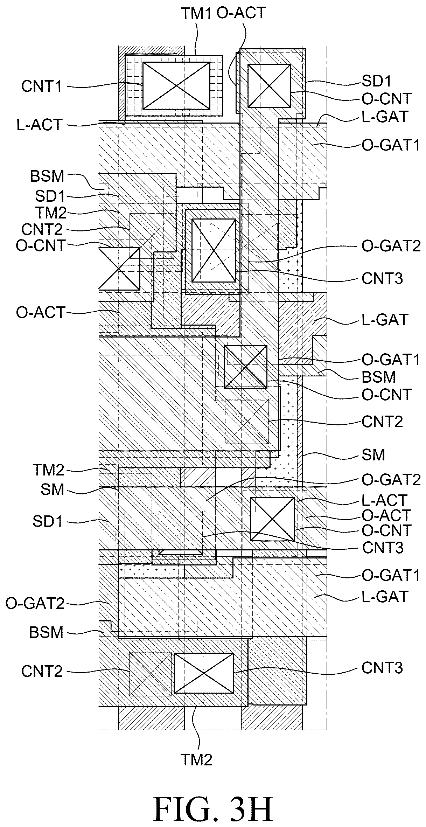

At least one of the plurality of transistors of the sub-pixel circuit may be an oxide semiconductor thin film transistor including a semiconductor layer that is an oxide semiconductor, and the remaining transistors may be transistors including a semiconductor layer that is a polycrystalline semiconductor. For example, the transistor including the semiconductor layer, which is a polycrystalline semiconductor, may be a low temperature polycrystalline silicon (LTPS) thin film transistor. In FIG. 3, it is illustrated as an example that the first transistor T1, the second transistor T2, and the fourth transistor T4 are LTPS thin film transistors, and the driving transistor DT, the third transistor T3, and the fifth transistor T5 are oxide semiconductor thin film transistors. Embodiments are not limited thereto. As an example, each of the plurality of transistors of the sub-pixel circuit may be a thin film transistor including any semiconductor layer such as an oxide semiconductor, a polycrystalline semiconductor, a compound semiconductor, an organic semiconductor, an amorphous semiconductor, etc., without being limited thereto.

The first electrode of each transistor to be described below may be referred to as a source electrode or a drain electrode, and the second electrode may be referred to as a drain electrode or a source electrode.

The first transistor T1 is switched according to the second emission signal EM(n). A gate electrode of the first transistor T1 may be connected to an emission signal line which applies a second emission signal EM(n). A first electrode of the first transistor T1 may be connected to a high potential power line which applies a high potential power voltage ELVDD, and a second electrode of the first transistor T1 may be connected to a first electrode of the driving transistor DT and a first electrode of the third transistor T3.

The second transistor T2 is switched according to a second scan signal SC2(n). A gate electrode of the second transistor T2 may be connected to a scan line to which the second scan signal SC2(n) is input, a first electrode of the second transistor T2 may be connected to a second electrode of the driving transistor DT and a first electrode of the fourth transistor T4, and a second electrode of the second transistor T2 may be connected to a data line to which a data voltage Vdata is applied.

The driving transistor DT is switched according to a voltage of a first capacitor electrode of the storage capacitor C. A gate electrode of the driving transistor DT may be connected to the first capacitor electrode of the storage capacitor C and the first electrode of the third transistor T3, the first electrode of the driving transistor DT may be connected to the second electrode of the first transistor T1 and the second electrode of the third transistor T3, and the second electrode of the driving transistor DT may be connected to the first electrode of the second transistor T2 and the first electrode of the fourth transistor T4.

The third transistor T3 is switched according to a first scan signal SC1(n). A gate electrode of the third transistor T3 may be connected to a scan line to which the first scan signal SC1(n) is input, a second electrode of the third transistor T3 may be connected to the gate electrode of the driving transistor DT and the first electrode of the storage capacitor C, and the first electrode of the third transistor T3 may be connected to the second electrode of the first transistor T1 and the first electrode of the driving transistor DT.

The fourth transistor T4 is switched according to a first emission signal EM(n-2). A gate electrode of the fourth transistor T4 may be connected to a emission signal line which applies the first emission signal EM(n-2), the first electrode of the fourth transistor T4 may be connected to the second electrode of the driving transistor DT and the first electrode of the second transistor T2, and a second electrode of the fourth transistor T4 may be connected to a first electrode of the fifth transistor T5, a second capacitor electrode of the storage capacitor C, and a first electrode of the light emitting element 130.

The fifth transistor T5 is switched according to the first emission signal EM(n-2). A gate electrode of the fifth transistor T5 may be connected to the emission signal line which applies the first emission signal EM(n-2), the first electrode of the fifth transistor T5 may be connected to the second electrode of the fourth transistor T4, the second capacitor electrode of the storage capacitor C, and the first electrode of the light emitting element 130. A second electrode of the fifth transistor T5 may be connected to an initialization signal line which applies the initialization voltage Vini.

The storage capacitor C stores the data voltage Vdata and a threshold voltage. The first capacitor electrode of the storage capacitor C may be connected to the gate electrode of the driving transistor DT and the first electrode of the third transistor T3, and the second capacitor electrode of the storage capacitor C may be connected to the second electrode of the fourth transistor T4 and the first electrode of the fifth transistor T5 and the first electrode of the light emitting element 130.

Meanwhile, the light emitting element 130 is connected between the fourth and fifth transistors T4 and T5 and the low potential power voltage ELVSS to emit light with a luminance proportional to the current of the driving transistor DT. The first electrode of the light emitting element 130 is connected to the second electrode of the fourth transistor T4, the first electrode of the fifth transistor T5, and the second capacitor electrode of the storage capacitor C. A second electrode of the light emitting element 130 may be connected to a low potential power line which applies the low potential power voltage ELVSS. The first electrode of the light emitting element 130 may be an anode electrode, and the second electrode may be a cathode electrode, but is not limited thereto.

As shown in FIG. 2, the second electrode of the first transistor T1, the second electrode of the third transistor T3, and the first electrode of the driving transistor DT constitute a first node N1. The second electrode of the driving transistor DT, the first electrode of the second transistor T2, and the first electrode of the fourth transistor T4 constitute a second node N2. The first electrode of the third transistor T3, the gate electrode of the driving transistor DT, and the first capacitor electrode of the storage capacitor C constitute a third node N3. Further, the second electrode of the fourth transistor T4, the first electrode of the fifth transistor T5, the second capacitor electrode of the capacitor C, and the first electrode of the light emitting element 130 constitute a fourth node N4. Embodiments are not limited thereto. As an example, the configuration of the sub-pixel circuit may be changed in various ways. As an example, the sub-pixel circuit may include at least one transistor and at least one capacitor, without being limited thereto. As an example, the sub-pixel circuit may have a 2T1C structure, a 3T1C structure, a 4T1C structure, a 5T2C structure, a 7T2C structure, etc., without being limited to the 6T1C structure as illustrated in Fig. 2.

Hereinafter, the structure of the display device 100 according to an exemplary embodiment of the present disclosure will be described in more detail with reference to FIGS. 3A to 6.

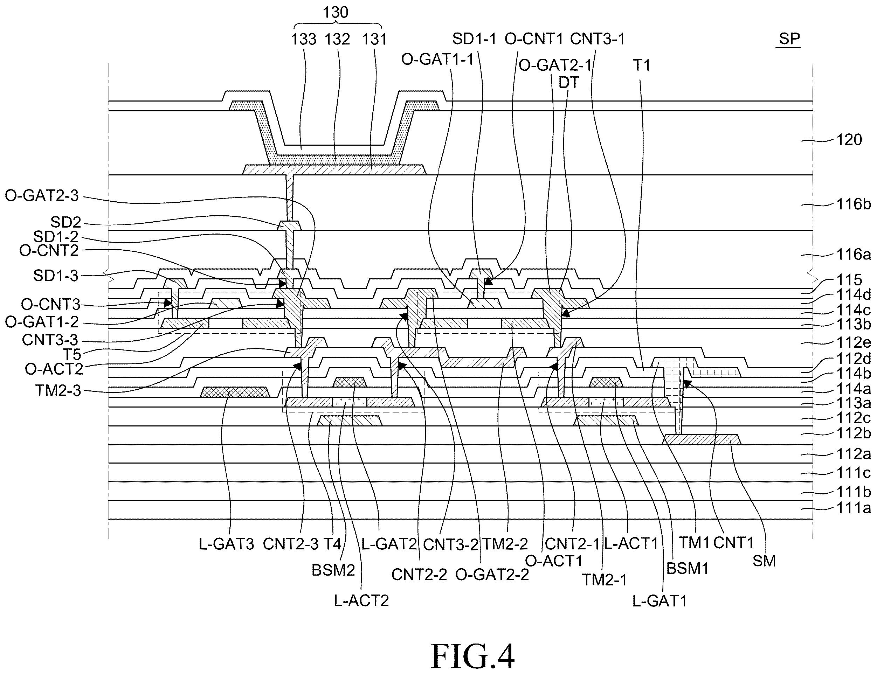

FIGS. 3A to 3G are schematic enlarged top plan views of a region of a display area of a display device according to an exemplary embodiment of the present disclosure. FIG. 3H is an enlarged plan view of the display area of the display device according to an exemplary embodiment of the present disclosure. FIG. 4 is a cross-sectional view of a sub-pixel of the display device according to the embodiment of the present disclosure.

In FIGS. 3A to 3G, a plurality of layers of the display device 100 according to the embodiment of the present disclosure illustrated in FIG. 3H are divided into some layers and illustrated. In FIGS. 3A to 3G, at least one overlapping layer may be included, but this is illustrated in duplicate for convenience of description, and as shown in FIG. 3H, each layer may be sequentially stacked without overlapping.

As described above with reference to FIGS. 1 and 2, in order to drive the light emitting element 130, various signals such as the scan signal, the emission signal, the data voltage, the initialization voltage, the high potential power voltage, and the low potential power voltage are used. These signals are applied to the sub-pixel through a plurality of signal lines including the gate line (e.g., the scan signal line and the emission signal line), the data line, the initialization signal line, the high potential power line, and the low potential power line, respectively.

Some signal lines among the plurality of signal lines may need to be connected to transistors that are disposed at a relatively lower layer among the plurality of transistors (e.g., DT and T1 to T5) described above with reference to FIG. 2. As such, when the corresponding signal line is disposed on an upper layer of a laminated structure under the light emitting element 130, there can arise a problem that a contact hole is required to penetrate all the way from the upper portion to the lower portion, which can preclude other components from being designed to overlap the lower area of the corresponding signal line. This can restrict a degree of freedom in design, and reduce efficiency and compactness of the display device.

In the display device 100 according to the exemplary configuration of the present disclosure, a first signal line SM is disposed on the lowermost layer on the substrate on the stacked structure under the light emitting element 130. Accordingly, other components, in particular, transistors disposed in multiple layers, may be disposed on the first signal line SM, so that the degree of design freedom is greatly increased, and the high-resolution image may be implemented, and the design area may be reduced without a large change in the arrangement of the components of the sub-pixel circuit.

Referring to FIGS. 4, 3A, and 3B together, in the display device 100 according to the exemplary embodiment of the present disclosure, the first signal line SM may be disposed on a substrate, and the blocking layer BSM may be disposed on the first signal line SM.

For example, referring to FIG. 4, a first buffer layer 112a is disposed on substrates 111a, 111b, and 111c, the first signal line SM is disposed on the first buffer layer 112a, a second buffer layer 112b is disposed on the first signal line SM, and the blocking layer BSM is disposed on the second buffer layer 112b. Embodiments are not limited thereto. As an example, although it is illustrated that the substrate includes three substrates 111a, 111b, and 111c, the substrate may include one single substrate, two substrates or more than three substrates. As an example, at least one of the first buffer layer 112a and the second buffer layer 112b may be omitted depending on the design.

The substrates 111a, 111b, and 111c serve to support and protect components of the display device 100 disposed thereon.

For example, when the substrate is made of polyimide (PI), moisture penetrates through the substrate made of polyimide (PI) to the thin film transistor or the light emitting element, thereby deteriorating the performance of the display device 100. In order to reduce or prevent deterioration of the performance of the display device 100 due to such moisture permeation, the display device 100 according to the exemplary embodiment of the present disclosure may have a double polyimide (PI) structure as the substrate, without being limited thereto.

For example, the substrate may include a first substrate 111a and a second substrate 111c each made of polyimide (PI), and an inorganic insulating layer 111b formed between the first substrate 111a and the second substrate 111c.

The inorganic insulating layer 111b may be formed of a single layer of silicon nitride (SiNx) or silicon oxide (SiOx) or a multi-layer thereof. For example, a silicon dioxide (SiO₂) material may be used as the inorganic insulating layer 111b, but is not limited thereto, and the inorganic insulating layer 111b may be formed of a double layer of silicon dioxide (SiO₂) and silicon nitride (SiNx). The inorganic insulating layer 111b blocks moisture from penetrating into the upper portion of the second substrate 111c. Further, when electric charges are charged in the first substrate 111a, the inorganic insulating layer 111b may block the charged electric charges from affecting the upper thin film transistor through the second substrate 111c. In this way, by blocking the electric charges charged in the lower polyimide (PI) through the inorganic insulating layer 111b, the reliability of the product may be improved, and a separate metal layer placement process for blocking the electric charges may be omitted, thereby simplifying the process and reducing the production cost.

The first buffer layer 112a, the second buffer layer 112b, and a third buffer layer 112c are disposed on the substrates 111a, 111b, and 111c. For example, the first buffer layer 112a may be a multi-buffer layer or a single-buffer layer, and the third buffer layer 112c may be an active buffer layer, without being limited thereto.

The blocking layer BSM is disposed below the third buffer layer 112c. The blocking layer BSM may be a layer serving as a light shield in order to reduce or prevent the semiconductor layer from being deteriorated by irradiating light incident from the outside of the display device onto the semiconductor layer. For example, the blocking layer BSM may be a metal layer, without being limited thereto. For example, the blocking layer BSM may have an area larger than that of an active layer (for example, a semiconductor layer) of the thin film transistor, but is not limited thereto. In addition, the blocking layer BSM may reduce or prevent a problem in which charges are introduced from the substrate. For example, when a voltage is applied to the gate electrode of the thin film transistor for a long time, charges of the substrate are introduced into the channel region of the active layer of the thin film transistor due to an electric field generated in the transistor to fluctuate the amount of charges in the corresponding channel region. The electric charge may be a hole or an electron depending on the polarity of the electric field. In this way, the substrate may cause a change in the threshold voltage of the thin film transistor by changing the current of the thin film transistor. This may cause a change in luminance of a pixel and an image sticking. Accordingly, the blocking layer BSM may be disposed between the substrate and the active layer to block unnecessary charge inflow from the substrate to the thin film transistor to reduce or prevent fluctuation of the threshold voltage of the thin film transistor, thereby reducing or preventing an image sticking and improving the display quality.

In this way, the blocking layer BSM is a metal layer disposed relatively below the sub-pixel stack structure. However, when the transistor to be disposed above the blocking layer BSM is a transistor having a semiconductor layer made of a polycrystalline semiconductor, planarization is required for crystallization of the semiconductor layer of the transistor, so that the thickness of the blocking layer BSM may be formed very thin. For example, the thickness of the blocking layer BSM may be 650 Å or less. In this case, the resistance of the blocking layer BSM is high, and thus it is disadvantageous to be used as a signal line.

Therefore, the second buffer layer 112b is additionally disposed between the multi-buffer layer and the active buffer layer, the first signal line SM is disposed on the first buffer layer 112a, the second buffer layer 112b is disposed on the first signal line SM, and the blocking layer BSM is disposed on the second buffer layer 112b. As illustrated in FIG. 3A, the first signal line SM may be a high potential power line which applies a high potential power voltage ELVDD or a data line which applies a data voltage Vdata, without being limited thereto. As an example, the blocking layer BSM may at least partially overlap the first signal line SM, or may not overlap the first signal line SM. As an example, one blocking layer BSM may overlap one, two or more first signal lines SM, without being limited thereto.

Referring to FIGS. 4 and 3C together, a plurality of transistors are disposed on the plurality of first signal lines SM and the blocking layer BSM.

For example, referring to FIGs. 3C and 4, the first transistor T1, the second transistor T2, and the fourth transistor T4 described above with reference to FIG. 2 may be disposed on the third buffer layer 112c. FIG. 4 illustrates a part of a cross-section of the display area AA in which a plurality of sub-pixels SP are disposed in the display device 100 according to an exemplary embodiment of the present disclosure. Accordingly, in FIG. 4, only cross-sections of the first transistor T1 and the fourth transistor T4 on the third buffer layer 112c are illustrated, but the second transistor T2 may also be disposed on the same layer as in FIG. 3C.

Referring to FIG. 3C, the active layer L-ACT of each of the first transistor T1 and the fourth transistor T4 is disposed on the high potential power line that apply the high potential power voltage ELVDD among the first signal lines SM and the blocking layer BSM, the active layer L-ACT of the second transistor T2 is disposed on the data line that apply the data voltage Vdata among the first signal lines SM and the blocking layer BSM, and the gate electrodes L-GAT of each of the first transistor T1, the second transistor T2, and the fourth transistor T4 are disposed on each active layer L-ACT. For example, the active layer may be referred to as a semiconductor layer. For example, as shown in FIG. 3C, a portion of the first transistor T1 and a portion of the fourth transistor T4 may overlap the first signal line SM that serves as the high-potential power line, and a portion of the second transistor T2 may overlap the first signal line SM that serves as the data line.

For example, as illustrated in FIG. 4, a first active layer L-ACT1 of the first transistor T1 and a second active layer L-ACT2 of the fourth transistor T4 are disposed on the third buffer layer 112c. In this case, a first blocking layer BSM1 is disposed below the first active layer L-ACT1 of the first transistor T1 and a second blocking layer BSM2 is disposed below the second active layer L-ACT2 of the fourth transistor T4.

The first active layer L-ACT1 and the second active layer L-ACT2 may include amorphous silicon or polycrystalline silicon, without being limited thereto. For example, the first active layer L-ACT1 and the second active layer L-ACT2 may include low temperature polysilicon (LTPS). Polysilicon materials have high mobility (100 cm²/Vs or more), low energy consumption, and excellent reliability.

Each of the first active layer L-ACT1 and the second active layer L-ACT2 may include a channel region in which a channel is formed when a transistor is driven, and a source region and a drain region on both sides of the channel region. For example, the source region and the drain region may be configured by ion doping (impurity doping) of the active layer. The source region and the drain region may be generated by doping ions into the polysilicon material, and the channel region may mean a portion in which the ions are not doped, but the polysilicon material remains, or a portion in which the ions are slightly doped, without being limited thereto.

A first gate insulating layer 113a is disposed on the first active layer L-ACT1 and the second active layer L-ACT2.

The first gate insulating layer 113a may be disposed on the entire substrate including the first active layer L-ACT1 and the second active layer L-ACT2. For example, the first gate insulating layer 113a may be configured by a single layer of silicon nitride (SiNx) or silicon oxide (SiOx) or a multi-layer thereof. Contact holes which are electrically connected to the source region and the drain region of each of the first active layer L-ACT1 of the first transistor T1 and the second active layer L-ACT2 of the fourth transistor T4 may be formed in the first gate insulating layer 113a.

A first gate electrode L-GAT1 of the first transistor T1 and a second gate electrode L-GAT2 of the fourth transistor T4 are disposed on the first gate insulating layer 113a. Further, an electrode layer L-GAT3 serving as a light shielding layer may be disposed on the first gate insulating layer 113a. Embodiments are not limited thereto. As an example, the electrode layer L-GAT3 may be omitted depending on the design.

The first gate electrode L-GAT1, the second gate electrode L-GAT2, and the electrode layer L-GAT3 may be formed of a single layer or a multi-layer formed of any one of molybdenum (Mo), copper (Cu), titanium (Ti), aluminum (Al), chromium (Cr), gold (Au), nickel (Ni), and neodymium (Nd) or an alloy thereof, without being limited thereto.

The first gate electrode L-GAT1 and the second gate electrode L-GAT2 may be formed on the first gate insulating layer 113a so as to overlap the channel regions of the first active layer L-ACT1 of the first transistor T1 and the second active layer L-ACT2 of the fourth transistor T4, respectively.

Meanwhile, the first capacitor electrode of the storage capacitor C described in FIG. 2 may be formed of the same material as the first gate electrode L-GAT1 and the second gate electrode L-GAT2 and may be formed on the same layer as the first gate electrode L-GAT1 and the second gate electrode L-GAT2, without being limited thereto. As an example, the first capacitor electrode may be formed by the same process as the first gate electrode L-GAT1 and the second gate electrode L-GAT2, but is not limited thereto. For example, the first capacitor electrode of the storage capacitor C may be omitted based on the driving characteristics of the display device 100 and the structure and type of the transistors.

Referring to FIGS. 4 and 3D together, a first metal pattern TM1 and a second metal pattern TM2 are disposed on the gate electrodes L-GAT of the plurality of transistors, and a first contact hole CNT1 and a second contact hole CNT2 for electrically connecting the first metal pattern TM1 and the second metal pattern TM2 to the active layer L-ACT of the transistors are formed.

For example, referring to FIG. 4, a first interlayer insulating layer 114a and a second interlayer insulating layer 114b are disposed on the first gate insulating layer 113a, the first gate electrode L-GAT1, the second gate electrode L-GAT2, and the electrode layer L-GAT3, and the first metal pattern TM1 is disposed on the second interlayer insulating layer 114b. Further, a fourth buffer layer 112d is disposed on the second interlayer insulating layer 114b and the first metal pattern TM1, and a second metal pattern TM2 is disposed on the fourth buffer layer 112d. Embodiments are not limited thereto. As an example, at least one of the first interlayer insulating layer 114a, the second interlayer insulating layer 114b and the fourth buffer layer 112d may be omitted depending on the design. As an example, the first metal pattern TM1 may be disposed on the same layer as the second metal pattern TM2, without being limited thereto.

The fourth buffer layer 112d may be configured by a single layer of silicon nitride (SiNx) or silicon oxide (SiOx) or a multi-layer thereof.

Meanwhile, the second capacitor electrode of the storage capacitor C described in FIG. 2 may be disposed on the first interlayer insulating layer 114a or the second interlayer insulating layer 114b. The second capacitor electrode may be formed of a single layer or a multi-layer formed of any one of molybdenum (Mo), copper (Cu), titanium (Ti), aluminum (Al), chromium (Cr), gold (Au), nickel (Ni), and neodymium (Nd) or an alloy thereof, without being limited thereto. The second capacitor electrode may be formed to overlap the first capacitor electrode. Further, the second capacitor electrode may be formed of the same material as, or a different material from the first capacitor electrode, without being limited thereto. The second capacitor electrode may be omitted based on the driving characteristics of the display device 100 and the structure and type of the transistor.

The first interlayer insulating layer 114a and the second interlayer insulating layer 114b may be configured by a single layer of silicon nitride (SiNx) or silicon oxide (SiOx) or a multi-layer thereof, without being limited thereto. Further, the first contact hole CNT1 and a 2-1 contact hole CNT2-1 for exposing the source region and the drain region of the first active layer L-ACT1 of the first transistor T1 may be formed in the first interlayer insulating layer 114a and the second interlayer insulating layer 114b.

For example, the source region of the first active layer L-ACT1 may be connected to the first metal pattern TM1 and the drain region may be connected to the second metal pattern TM2. However, depending on the design of the sub-pixel circuit, the first metal pattern TM1 may be connected to the drain region, and the second metal pattern TM2 may be connected to the source region.

In this case, the first contact hole CNT1 is formed to penetrate the second interlayer insulating layer 114b, the first interlayer insulating layer 114a, the first gate insulating layer 113a, the third buffer layer 112c, and the second buffer layer 112b, and the first metal pattern TM1 is connected to the source region of the first active layer L-ACT1 of the first transistor T1 through the first contact hole CNT1. Also, the first metal pattern TM1 is connected to the first signal line SM through the first contact hole CNT1. In this way, the first signal line SM is electrically connected to the first active layer L-ACT1 of the first transistor T1 through the first metal pattern TM1.

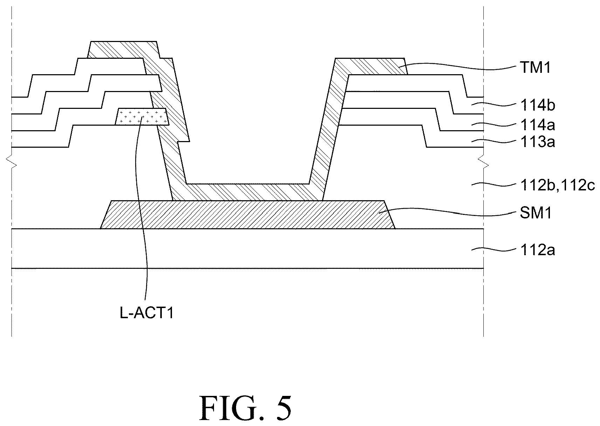

FIG. 5 is a cross-sectional view for explaining an example of a structure in which a metal pattern of the display device according to an exemplary embodiment of the present disclosure is in contact with an active layer.

FIG. 5 illustrates a cross-sectional view when a partial area of the sub-pixel circuit is viewed in a direction different from that of FIG. 4.

As illustrated in FIG. 5, the first metal pattern TM1 is disposed to a lower portion along a side surface of a contact hole penetrating through the second interlayer insulating layer 114b, the first interlayer insulating layer 114a, the first gate insulating layer 113a, the third buffer layer 112c, and the second buffer layer 112b so that a lower surface thereof is in contact with the first signal line SM on the first buffer layer 112a. At this time, a part of the first active layer L-ACT1 of the first transistor T1 protrudes from the side surface of the contact hole penetrating through the first interlayer insulating layer 114a, the first gate insulating layer 113a, the third buffer layer 112c, and the second buffer layer 112b, and the side surface of the first metal pattern TM1 is disposed to cover the protruding part of the first active layer L-ACT1 and is in side contact with the first active layer L-ACT1 of the first transistor T1. In this way, the first signal line SM and the first active layer L-ACT1 of the first transistor T1 may be electrically connected through the first metal pattern TM1. As an example, the first metal pattern TM1 may be disposed to contact with an upper surface, a side surface and a lower surface of the part of the first active layer L-ACT1 of the first transistor T1 protruding from the side surface of the contact hole, without being limited thereto. As an example, the first metal pattern TM1 may be continuous at the part of the first active layer L-ACT1 of the first transistor T1 protrudes from the side surface of the contact hole, without being limited thereto.

Referring to FIG. 4, each of the 2-1 contact hole CNT2-1, a 2-2 contact hole CNT2-2, and a 2-3 contact hole CNT2-3 is formed by passing through the fourth buffer layer 112d, the second interlayer insulating layer 114b, the first interlayer insulating layer 114a, and the first gate insulating layer 113a. A 2-1 metal pattern TM2-1 is connected to the drain region of the first active layer L-ACT1 of the first transistor T1 through the 2-1 contact hole CNT2-1. A 2-2 metal pattern TM2-2 may be connected to the source region of the second active layer L-ACT2 of the fourth transistor T4, and a 2-3 metal pattern TM2-3 may be connected to the drain region of the second active layer L-ACT2 of the fourth transistor T4 through the 2-3 contact hole CNT2-3.

Referring to FIGS. 4 and 3E together, a plurality of transistors are disposed on the second metal pattern TM2.

For example, referring to FIG. 4, a fifth buffer layer 112e may be disposed on the 2-1 metal pattern TM2-1, the 2-2 metal pattern TM2-2, the 2-3 metal pattern TM2-3, and the fourth buffer layer 112d, and the third transistor T3, the driving transistor DT, and the fifth transistor T5 described in FIG. 2 may be disposed on the fifth buffer layer 112e. In FIG. 4, only cross-sections of the driving transistor DT and the fifth transistor T5 on the fifth buffer layer 112e are illustrated, but the third transistor T3 may also be disposed on the same layer as in FIG. 3E. For example, referring to FIGS. 3C and 3E together, a portion of the driving transistor DT may overlap the first signal line SM that serves as the high-potential power line, and a portion of the third transistor T3 and a portion of the fifth transistor T5 may overlap the first signal line SM that serves as the data line.

The fifth buffer layer 112e may be configured by a single layer of silicon nitride (SiNx) or silicon oxide (SiOx) or a multi-layer thereof. Contact holes for exposing each of the 2-1 metal pattern TM2-1, the 2-2 metal pattern TM2-2, and the 2-3 metal pattern TM2-3 may be formed in the fifth buffer layer 112e.

Referring to FIG. 3E, an active layer O-ACT of each of the third transistor T3, the driving transistor DT, and the fifth transistor T5 is disposed on the second metal pattern TM2, and a gate electrodes O-GAT1 of each of the third transistor T3, the driving transistor DT, and the fifth transistor T5 are disposed on each of the active layers O-ACT.

For example, as illustrated in FIG. 4, a third active layer O-ACT1 of the driving transistor DT and a fourth active layer O-ACT2 of the fifth transistor T5 are disposed on the fifth buffer layer 112e.

The third active layer O-ACT1 and the fourth active layer O-ACT2 may be formed of an oxide semiconductor, without being limited thereto. As an example, the third active layer O-ACT1 and the fourth active layer O-ACT2 may be formed of the same semiconductor material or different semiconductor materials, without being limited thereto. The thin film transistor including an active layer made of an oxide semiconductor has a small off-current, so that the size of the auxiliary capacitance may be reduced, and thus is suitable for a high-resolution display device. For example, the third active layer O-ACT1 and the fourth active layer O-ACT2 may be made of metal oxides, and for example, may be made of various metal oxides such as indium-gallium-zinc-oxide (IGZO), but are not limited thereto. For example, the third active layer O-ACT1 and the fourth active layer O-ACT2 may be formed of indium-zinc-oxide (IZO), indium-gallium-tin-oxide (IGTO), or other metal oxides such as indium-gallium-oxide (IGO), without being limited thereto. The third active layer O-ACT1 and the fourth active layer O-ACT2 may be formed by depositing a metal oxide on the fifth buffer layer 112e, performing a heat treatment process for stabilization, and then patterning the metal oxide. Each of the third active layer O-ACT1 and the fourth active layer O-ACT2 may include a channel region in which a channel is formed when a transistor is driven, and a source region and a drain region on both sides of the channel region.

A second gate insulating layer 113b is disposed on the third active layer O-ACT1 and the fourth active layer O-ACT2.

The second gate insulating layer 113b may be disposed on the entire substrate including the third active layer O-ACT1 and the fourth active layer O-ACT2. For example, the second gate insulating layer 113b may be configured by a single layer of silicon nitride (SiNx) or silicon oxide (SiOx) or a multi-layer thereof, without being limited thereto. Contact holes which are electrically connected to the source region and the drain region of each of the third active layer O-ACT1 of the driving transistor DT and the fourth active layer O-ACT2 of the fifth transistor T5 may be formed in the second gate insulating layer 113b.

A third gate electrode O-GAT1-1 of the driving transistor DT and a fourth gate electrode O-GAT1-2 of the fifth transistor T5 are disposed on the second gate insulating layer 113b.

The third gate electrode O-GAT1-1 and the fourth gate electrode O-GAT1-2 may be formed of a single layer or a multi-layer formed of any one of molybdenum (Mo), copper (Cu), titanium (Ti), aluminum (Al), chromium (Cr), gold (Au), nickel (Ni), and neodymium (Nd) or an alloy thereof, without being limited thereto.

Meanwhile, the electrode layer L-GAT3 serving as the light blocking layer described above may be disposed below the fifth thin film transistor T5. For example, as illustrated in FIG. 4, the electrode layer L-GAT3 may be disposed on the first gate insulating layer 113a so as to overlap the fourth active layer O-ACT2 of the fifth transistor T5.

The third gate electrode O-GAT1-1 and the fourth gate electrode O-GAT1-2 may be formed on the second gate insulating layer 113b so as to overlap the channel regions of the third active layer O-ACT1 of the driving transistor DT and the fourth active layer O-ACT2 of the fifth transistor T5, respectively.

Referring to FIGS. 4 and 3F together, a third metal pattern O-GAT2 is disposed on the gate electrodes O-GAT1 of the plurality of transistors, and a third contact hole CNT3 for electrically connecting the third metal pattern O-GAT2 to the active layer O-ACT of the lower transistor and the second metal pattern TM2 is formed.

For example, referring to FIG. 4, a third interlayer insulating layer 114c is disposed above the third gate electrode O-GAT1-1 and the fourth gate electrode O-GAT1-2, and a 3-1 metal pattern O-GAT2-1, a 3-2 metal pattern O-GAT2-2, and a 3-3 metal pattern O-GAT2-3 are disposed on the third interlayer insulating layer 114c.

The third interlayer insulating layer 114c may be configured by a single layer of silicon nitride (SiNx) or silicon oxide (SiOx) or a multi-layer thereof, without being limited thereto. Further, a 3-1 contact hole CNT3-1 and a 3-2 contact hole CNT3-2 for exposing the source region and the drain region of the third active layer O-ACT1 of the driving transistor DT may be formed in the third interlayer insulating layer 114c. In addition, a 3-3 contact hole CNT3-3 for exposing the source region of the fourth active layer O-ACT2 of the fifth transistor T5 may be formed in the third interlayer insulating layer 114c. For example, a source region of the third active layer O-ACT1 may be connected to the 3-1 metal pattern O-GAT2-1, and a drain region of the third active layer O-ACT1 may be connected to the 3-2 metal pattern O-GAT2-2. Further, a source region of the fourth active layer O-ACT2 may be connected to the 3-3 metal pattern O-GAT2-3. However, depending on the design of the sub-pixel circuit, the 3-1 metal pattern O-GAT2-1 and the 3-3 metal pattern O-GAT2-3 may be connected to the drain region, and the 3-2 metal pattern O-GAT2-2 may be connected to the source region.

In this case, the 3-1 contact hole CNT3-1, the 3-2 contact hole CNT3-2, and the 3-3 contact hole CNT3-3 are formed to penetrate the third interlayer insulating layer 114c, the second gate insulating layer 113b, and the fifth buffer layer 112e.

The 3-1 metal pattern O-GAT2-1 is connected to the source region of the third active layer O-ACT1 of the driving transistor TD through the 3-1 contact hole CNT3-1, and the 3-1 metal pattern O-GAT2-1 is connected to the 2-1 metal pattern TM2-1 through the 3-1 contact hole CNT3-1. The 3-2 metal pattern O-GAT2-2 is connected to the drain region of the third active layer O-ACT1 of the driving transistor TD through the 3-2 contact hole CNT3-2, and the 3-2 metal pattern O-GAT2-2 is connected to the 2-2 metal pattern TM2-2 through the 3-2 contact hole CNT3-2. In this way, the driving transistor DT is electrically connected to the lower first transistor T1.

The 3-3 metal pattern O-GAT2-3 is connected to the source region of the fourth active layer O-ACT2 of the fifth transistor T5 through the 3-3 contact hole CNT3-3, and the 3-3 metal pattern O-GAT2-3 is connected to the 2-3 metal pattern TM2-3 through the 3-3 contact hole CNT3-3. In this way, the fifth transistor T5 is electrically connected to the fourth transistor T4 therebelow.

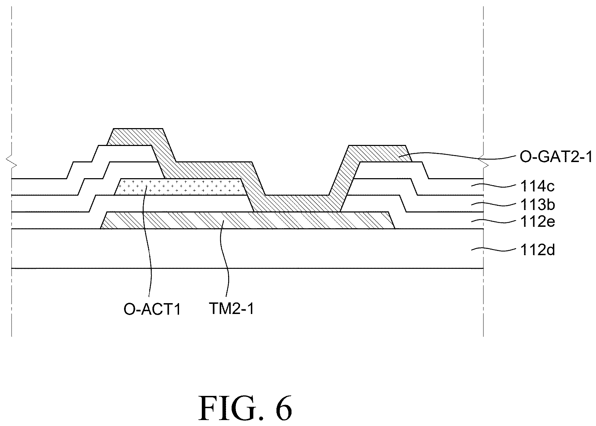

FIG. 6 is a cross-sectional view for explaining another example of a structure in which a metal pattern of the display device according to an exemplary embodiment of the present disclosure is in contact with an active layer.

FIG. 6 illustrates a cross-sectional view when a partial area of the sub-pixel circuit is viewed in a direction different from that of FIG. 4.

As illustrated in FIG. 6, the 3-1 metal pattern O-GAT2-1 is disposed along a side surface of a contact hole penetrating through the third interlayer insulating layer 114c, the second gate insulating layer 113b, and the fifth buffer layer 112e to a lower portion so that a lower surface thereof is in contact with the 2-1 metal pattern TM2-1 on the fourth buffer layer 112d. At this time, a part of the third active layer O-ACT1 of the driving transistor DT protrudes from the side surface of the contact hole penetrating through the third interlayer insulating layer 114c, the second gate insulating layer 113b, and the fifth buffer layer 112e, and the side surface of the 3-1 metal pattern O-GAT2-1 is disposed to cover the protruding part of the third active layer O-ACT1 and is in side contact with the third active layer O-ACT1 of the driving transistor DT. In this way, the third active layer O-ACT1 of the driving transistor TD may be electrically connected to the first active layer L-ACT1 of the first transistor T1 through the 3-1 contact hole CNT3-1 and the 2-1 contact hole CNT2-1.

In this way, the third active layer O-ACT1 of the driving transistor TD and the second active layer L-ACT2 of the fourth transistor T4 may be electrically connected through the 3-2 contact hole CNT3-2 and the 2-2 contact hole CNT2-2. In addition, the fourth active layer O-ACT2 of the fifth transistor T5 and the second active layer L-ACT2 of the fourth transistor T4 may be electrically connected through the 3-3 contact hole CNT3-3 and the 2-3 contact hole CNT2-3.

Referring to FIGS. 4 and 3G together, a plurality of second signal lines SD1 is disposed on the third metal pattern O-GAT2, and a fourth contact hole O-CNT for electrically connecting the second signal line SD1 to the gate electrode O-GAT1 of the transistor, the third metal pattern O-GAT2, and the active layer O-ACT of the transistor is formed. The second signal line SD1 may be a scan line configured to apply a scan signal, an emission signal line configured to apply an emission signal, an initialization signal line configured to apply an initialization voltage, or a low potential power line configured to apply a low potential power voltage, without being limited thereto.

For example, referring to FIG. 4, a fourth interlayer insulating layer 114d is disposed on the 3-1 metal pattern O-GAT2-1, the 3-2 metal pattern O-GAT2-2, and the 3-3 metal pattern O-GAT2-3, and a 2-1 signal line SD1-1, a 2-2 signal line SD1-2, and a 2-3 signal line SD1-3 are disposed on the fourth interlayer insulating layer 114d.

The fourth interlayer insulating layer 114d may be configured by a single layer of silicon nitride (SiNx) or silicon oxide (SiOx) or a multi-layer thereof, without being limited thereto. Further, in the fourth interlayer insulating layer 114d, a 4-1 contact hole O-CNT1 for exposing the third gate electrode O-GAT1-1 of the driving transistor DT, a 4-2 contact hole O-CNT2 for exposing the 3-3 metal pattern O-GAT2-3, and a 4-3 contact hole O-CNT3 for exposing the drain region of the fourth active layer O-ACT2 of the fifth transistor T5 may be formed.

For example, the third gate electrode O-GAT1-1 of the driving transistor DT may be connected to the 2-1 signal line SD1-1 configured to apply a scan signal, the 3-3 metal pattern O-GAT2-3 may be connected to the 2-2 signal line SD1-2, and the drain region of the fourth active layer O-ACT2 of the fifth transistor T5 may be connected to the 2-3 signal line SD1-3 configured to apply an initialization voltage. However, depending on the design of the sub-pixel circuit, the source region of the fourth active layer O-ACT2 may be connected to the 2-3 signal line SD1-3.

In this case, the 4-1 contact hole O-CNT1 is formed to penetrate the fourth interlayer insulating layer 114d and the third interlayer insulating layer 114c, and the 2-1 signal line SD1-1 is electrically connected to the third gate electrode O-GAT1-1 through the 4-1 contact hole O-CNT1. The 4-2 contact hole O-CNT2 is formed to penetrate the fourth interlayer insulating layer 114d, and the 2-2 signal line SD1-2 is electrically connected to the 3-3 metal pattern O-GAT2-3 through the 4-2 contact hole O-CNT2. Further, the 4-3 contact hole O-CNT3 is formed by passing through the fourth interlayer insulating layer 114d, the third interlayer insulating layer 114c, and the second gate insulating layer 113b. Further, the 2-3 signal line SD1-3, which is an initialization signal line, is electrically connected to the fourth active layer O-ACT2 of the fifth transistor T5 through the 4-3 contact hole O-CNT3.

For example, at least some of the metal patterns TM1, TM2, O-GAT2, and SD1 in direct contact with the source region and the drain region of the active layer for each of the plurality of transistors described with reference to FIGS. 3A to 3G and 4 may be referred to as source electrodes and drain electrodes.

As described above, a plurality of layers of the display device 100 according to the exemplary embodiment of the present disclosure may be sequentially stacked as shown in FIG. 3H.

Referring to FIG. 4, an inorganic material layer 115 may be disposed on the fourth interlayer insulating layer 114d and the 2-1 signal line SD1-1, the 2-2 signal line SD1-2, and the 2-3 signal line SD1-3.

The inorganic material layer 115 may be a passivation layer for protecting a plurality of transistors (e.g., the driving transistor DT, the fifth transistor T5) and may be formed of silicon oxide (SiOx), silicon nitride (SiNx), or a multi-layer thereof, without being limited thereto.

A first planarization layer 116a and a second planarization layer 116b are disposed on the inorganic material layer 115.

The first planarization layer 116a may be an organic layer for planarizing and protecting upper portions of the plurality of transistors (e.g., the driving transistor DT, the fifth transistor T5, etc.). For example, the first planarization layer 116a may be formed of an organic material such as acrylic resin, epoxy resin, phenolic resin, polyamide resin, or polyimide resin, without being limited thereto.

As an example, a auxiliary electrode SD2 may be disposed on the first planarization layer 116a.

The auxiliary electrode SD2 may be connected to the 2-2 signal line SD1-2 through a contact hole formed in the first planarization layer 116a and the inorganic material layer 115. As an example, the auxiliary electrode SD2 may be connected to the 2-2 signal line SD1-2 to be electrically connected to the 3-3 metal pattern O-GAT2-3, the fourth active layer O-ACT2 of the fifth transistor T5, the 2-3 metal pattern TM2-3, and the second active layer L-ACT2 of the fourth transistor T4, respectively.

Further, the auxiliary electrode SD2 may serve to electrically connect the transistor and a first electrode 131 of the light emitting element 130. For example, the auxiliary electrode SD2 may be formed of a single layer or a multi-layer formed of any one of molybdenum (Mo), copper (Cu), titanium (Ti), aluminum (Al), chromium (Cr), gold (Au), nickel (Ni), and neodymium (Nd) or an alloy thereof, without being limited thereto. The auxiliary electrode SD2 may be formed of the same material as the metal pattern connected to the source region and the drain region included in the active layer of the transistors. Embodiments are not limited thereto. As an example, the auxiliary electrode SD2 may be formed of a different material from the metal pattern connected to the source region and the drain region included in the active layer of the transistors. As an example, the auxiliary electrode SD2 may be omitted depending on the design.

A second planarization layer 116b is disposed on the auxiliary electrode SD2 and the first planarization layer 116a. For example, the second planarization layer 116b may be formed of an organic material such as acrylic resin, epoxy resin, phenolic resin, polyamide resin, or polyimide resin, without being limited thereto.

The light emitting element 130 is disposed on the second planarization layer 116b.

The light emitting element 130 includes the first electrode 131, an emission layer 132, and a second electrode 133. For example, the first electrode 131 may be an anode electrode, and the second electrode 133 may be a cathode electrode, but is not limited thereto.

Further, a bank 120 is disposed on the second planarization layer 116b. The bank 120 may include an open area exposing a portion corresponding to an emission area of each sub-pixel.

The first electrode 131 of the light emitting element 130 is disposed on the second planarization layer 116b. The first electrode 131 may be formed of a metallic material and may be electrically connected to the auxiliary electrode SD2 through a contact hole provided in the second planarization layer 116b.

For example, when the display device 100 according to the exemplary embodiment of the present disclosure is a top emission type, light emitted from the light emitting element 130 is emitted to the top of the substrate. In this case, the first electrode 131 may further include a transparent conductive layer and a reflective layer on the transparent conductive layer. For example, the transparent conductive layer may be formed of a transparent conductive oxide such as Indium Tin Oxide (ITO) or Indium Zinc Oxide (IZO), and the reflective layer may be formed of silver (Ag), aluminum (Al), gold (Au), molybdenum (Mo), tungsten (W), chromium (Cr), or an alloy thereof, without being limited thereto.

The bank 120 may be disposed while covering both ends of the first electrode 131, and a part of the first electrode 131 may be exposed through the open area of the bank 120. For example, the bank 120 may be made of an inorganic insulating material, such as silicon nitride (SiNx) or silicon oxide (SiOx), or an organic insulating material, such as benzocyclobutene (BCB)-based resin, acrylicbased resin, or polyimide-based resin, but is not limited thereto.

The emission layer 132 of the light emitting element 130 is disposed in the open area of the bank 120 and around the open area. Accordingly, the emission layer 132 may be disposed on the first electrode 131 exposed through the open area of the bank 120. For example, the emission layer 132 may include a plurality of organic films, without being limited thereto. The second electrode 133 is disposed on the emission layer 132 of the light emitting element 130.

Meanwhile, the display device 100 according to the exemplary embodiment of the present disclosure may further include an encapsulation layer disposed on the light emitting element 130.

The encapsulation layer may have a single layer structure or a multi-layer structure. For example, the encapsulation layer may include a first encapsulation layer, a second encapsulation layer, and a third encapsulation layer. At this time, the first encapsulation layer and the third encapsulation layer may be configured by inorganic films, and the second encapsulation layer may be configured by an organic film, without being limited thereto. Among the first encapsulation layer, the second encapsulation layer, and the third encapsulation layer, the second encapsulation layer is the thickest and may serve as a planarization layer.

In the encapsulation layer, the first encapsulation layer may be disposed most adjacent to the light emitting element 130. As an example, the first encapsulation layer may be disposed on the second electrode 133 of the light emitting element 130.

The first encapsulation layer may be formed of an inorganic insulating material on which low-temperature deposition may be performed. For example, the first encapsulation layer may be made of silicon nitride (SiNx), silicon oxide (SiOx), silicon oxynitride (SiON), or aluminum oxide (Al₂O₃), without being limited thereto. Since the first encapsulation layer is deposited in a low temperature atmosphere, it is possible to reduce or prevent the damage of the emission layer 132 containing an organic material vulnerable to a high temperature atmosphere during the deposition process.

The second encapsulation layer may be formed to have a smaller area than the first encapsulation layer. **In** this case, the second encapsulation layer may be formed to expose both ends of the first encapsulation layer. The second encapsulation layer may serve as a buffer to alleviate stress between layers due to bending of the display device 100 having a flexible characteristic and to enhance planarization performance. For example, the second encapsulation layer may be made of an organic insulating material such as acrylic resin, epoxy resin, polyimide, polyethylene, or silicon oxy carbon (SiOC), without being limited thereto. For example, the second encapsulation layer may be formed by an inkjet method, but is not limited thereto.

The third encapsulation layer may be formed above the substrate on which the second encapsulation layer is formed so as to cover upper surfaces and side surfaces of the second encapsulation layer and the first encapsulation layer, respectively. **In** this case, the third encapsulation layer may reduce, minimize or block the permeation of external moisture or oxygen into the first encapsulation layer and the second encapsulation layer. For example, the third encapsulation layer may be made of an inorganic insulating material, such as silicon nitride (SiNx), silicon oxide (SiOx), silicon oxynitride (SiON), or aluminum oxide (Al₂O₃), without being limited thereto.

In addition, as an example, the display device 100 according to the exemplary embodiment of the present disclosure may further include a color filter unit and a touch sensing unit disposed on the encapsulation layer, but is not limited thereto.

For example, a touch buffer film for disposing the touch sensing unit may be disposed on the third encapsulation layer, and a plurality of touch electrodes of the touch sensing unit may be disposed on the touch buffer film. The touch electrodes may include a touch sensor metal and a bridge metal positioned on different layers, and a touch interlayer insulating film may be disposed between the touch sensor metal and the bridge metal.

Further, the display device 100 according to the exemplary embodiment of the present disclosure may further include an organic material layer covering the color filter unit and the touch sensing unit on the encapsulation layer. For example, the organic material layer covering the touch electrode of the touch sensing unit may be disposed, and such the organic material layer may be formed of an organic insulating film.

Further, the display device 100 according to the exemplary embodiment of the present disclosure may further include a polarizing layer and a cover member disposed on the encapsulation layer, without being limited thereto.

The polarizing layer may suppress reflection of external light on the display area AA of the substrate. For example, when the display device 100 is used at the outside, external natural light may be introduced and reflected by a reflective layer included in the first electrode 131 of the light emitting element 130 or reflected by an electrode made of a metal disposed below the light emitting element 130. The image of the display device 100 may not be visually recognized due to the reflected light. The polarization layer may polarize the light introduced from the outside in a specific direction and suppress the reflected light from being emitted to the outside of the display device 100.

In addition, the cover member such as a cover glass may protect the components of the display device 100 from external impacts and reduce or prevent damage such as scratches. The cover glass may be bonded onto the polarizing layer by an adhesive layer. For example, the adhesive layer may be formed using an optically transparent display adhesive such as a pressure sensitive adhesive, an optical clear adhesive (OCR), or an optical clear resin (OCR), but is not limited thereto.

The exemplary embodiments of the present disclosure can also be described as follows:

A display device according to an exemplary embodiment of the present disclosure includes a substrate including a plurality of sub-pixels. The display device further includes a first buffer layer disposed on the substrate. The display device further includes a plurality of first signal lines disposed on the first buffer layer. The display device further includes a second buffer layer disposed on the plurality of first signal lines. The display device further includes a first transistor disposed on the second buffer layer and electrically connected to one of the plurality of first signal lines. The display device further includes a third buffer layer disposed on the first transistor. The display device further includes a second transistor disposed on the third buffer layer.

The first transistor may include a semiconductor layer made of a polycrystalline semiconductor, and the second transistor may include a semiconductor layer made of an oxide semiconductor.

According to another feature of the present disclosure, the plurality of first signal lines may include a high potential power line and a data line.

According to another feature of the present disclosure, the first transistor and the second transistor may overlap the high potential power line.

According to another feature of the present disclosure, the first transistor and the second transistor may overlap the data line.

According to another feature of the present disclosure, the display device may further include a fourth buffer layer disposed below the second buffer layer and disposed on the first buffer layer and the plurality of first signal lines; and a blocking layer disposed on the fourth buffer layer and disposed to overlap the semiconductor layer of the first transistor.

According to another feature of the present disclosure, the display device may further include an insulating layer disposed on a gate electrode of the first transistor; and a metal pattern disposed on the insulating layer, wherein the metal pattern may electrically connect the first transistor and the first signal line.

According to another feature of the present disclosure, the display device may further include a plurality of second signal lines disposed on the same layer as a source electrode and a drain electrode of the second transistor, wherein one of the plurality of second signal lines may be electrically connected to the second transistor.

According to another feature of the present disclosure, the plurality of second signal lines may include a scan line, an emission signal line, and an initialization signal line.

A display device according to another embodiment of the present disclosure includes a substrate including a plurality of sub-pixels. The display device further includes a light emitting element included in each of the plurality of sub-pixels. The display device further includes a plurality of first signal lines disposed on the substrate and including a data line which supplies a data voltage and a high potential power line which supplies a high potential power voltage. The display device further includes a plurality of sub-pixel circuits disposed in each of the plurality of sub-pixels on the substrate and electrically connected to the plurality of first signal lines. The display device further includes a first transistor including a first electrode connected to the high potential power line, a gate electrode to which an emission signal is input, and a second electrode connected to a first node. The display device further includes a second transistor including a first electrode connected to a second node, a gate electrode to which a scan signal is input, and a second electrode connected to the data line. The plurality of first signal lines disposed below the first transistor and the second transistor.

According to another feature of the present disclosure, the display device may further include a plurality of second signal lines including a first scan line configured to supply a first scan signal, a second scan line configured to supply a second scan signal, a first emission signal line configured to supply a first emission signal, a second emission signal line configured to supply a second emission signal, and an initialization signal line configured to supply an initialization voltage.

According to another feature of the present disclosure, the plurality of sub-pixel circuits may further include: a driving transistor including a first electrode connected to a first node, a gate electrode connected to a third node, and a second electrode connected to a second node; a third transistor including a first electrode connected to the third node, a gate electrode connected to a first scan line, and a second electrode connected to the first node; a fourth transistor including a first electrode connected to the second node, a gate electrode connected to a second emission signal line, and a second electrode connected to the fourth node; a capacitor connected between the third node and the fourth node; and a fifth transistor including a first electrode connected to the fourth node, a gate electrode connected to the initialization signal line, and a second electrode connected to the light emitting element.

According to another feature of the present disclosure, the first transistor, the second transistor, and the fourth transistor may each include a semiconductor layer made of low temperature polycrystalline silicon (LTPS), and the third transistor, the driving transistor, and the fifth transistor may each include a semiconductor layer made of oxide semiconductor.

According to another feature of the present disclosure, the third transistor, the driving transistor, and the fifth transistor may be disposed above the first transistor, the second transistor, and the fourth transistor, and the plurality of second signal lines may be disposed on the same layer as the first electrode and the second electrode of each of the third transistor, the driving transistor, and the fifth transistor.

Although the exemplary embodiments of the present disclosure have been described in detail with reference to the accompanying drawings, the present disclosure is not limited thereto and may be embodied in various forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described embodiments are illustrative in all aspects and do not limit the present disclosure. All the technical concepts in the equivalent scope of the present disclosure should be construed as falling within the scope of the present disclosure.

Also disclosed here in are the following numbered items:
1. A display device, comprising:
   a substrate including a plurality of sub-pixels;
   a light emitting element included in each of the plurality of sub-pixels;
   a plurality of first signal lines disposed on the substrate and including a data line supplying a data voltage and a high potential power line supplying a high potential power voltage; and
   a plurality of sub-pixel circuits disposed in each of the plurality of sub-pixels on the substrate and electrically connected to the plurality of first signal lines,
   wherein the plurality of sub-pixel circuits includes:
      a first transistor including a first electrode connected to the high potential power line, a gate electrode to which a second emission signal is input, and a second electrode connected to a first node connected to a first electrode of a driving transistor for driving the light emitting element; and
      a second transistor including a first electrode connected to a second node connected to a second electrode of the driving transistor, a gate electrode to which a second scan signal is input, and a second electrode connected to the data line,
      wherein the plurality of first signal lines is disposed below the first transistor and the second transistor.
2. The display device according to item 1, further comprising:
   a plurality of second signal lines including a first scan line supplying a first scan signal, a second scan line supplying the second scan signal, a first emission signal line supplying a first emission signal, a second emission signal line supplying the second emission signal, and an initialization signal line supplying an initialization voltage.
3. The display device according to item 2, wherein the plurality of sub-pixel circuits further includes:
   the driving transistor including the first electrode connected to the first node, a gate electrode connected to a third node, and the second electrode connected to the second node;
   a third transistor including a first electrode connected to the third node, a gate electrode connected to the first scan line, and a second electrode connected to the first node;
   a fourth transistor including a first electrode connected to the second node, a gate electrode connected to the first emission signal line, and a second electrode connected to a fourth node;
   a capacitor connected between the third node and the fourth node; and
   a fifth transistor including a first electrode connected to the fourth node, a gate electrode connected to the first emission signal line, and a second electrode connected to the initialization signal line.
4. The display device according to item 3, wherein the first transistor, the second transistor, and the fourth transistor each include a semiconductor layer made of low temperature polycrystalline silicon LTPS, and
   the third transistor, the driving transistor, and the fifth transistor each include a semiconductor layer made of oxide semiconductor.
5. The display device according to item 4, wherein the third transistor, the driving transistor, and the fifth transistor are disposed above the first transistor, the second transistor, and the fourth transistor, and
   the plurality of second signal lines is disposed above the first electrode and the second electrode of each of the third transistor, the driving transistor, and of the fifth transistor.
6. A display device, comprising:
   a substrate including a plurality of sub-pixels;
   a plurality of first signal lines disposed on the substrate;
   a first buffer layer disposed on the plurality of first signal lines;
   a first transistor disposed on the first buffer layer and electrically connected to one first signal line of the plurality of first signal lines,
   wherein a source electrode of the first transistor overlaps the one first signal line, and is electrically connected to both of the one first signal line and an active layer of the first transistor via one contact hole continually formed by penetrating the first buffer layer.
7. The display device according to item 6, wherein a part of the active layer of the first transistor protrudes from a side surface of the contact hole to be covered and in side contact with the source electrode of the first transistor.

## Claims

1. A display device, comprising:
a substrate including a plurality of sub-pixels;
a plurality of first signal lines disposed on the substrate;
a first buffer layer disposed on the plurality of first signal lines;
a first transistor disposed on the first buffer layer and electrically connected to a first signal line among the plurality of first signal lines;
a second buffer layer disposed on the first transistor; and
a second transistor disposed on the second buffer layer.

2. The display device according to claim 1, wherein the first transistor includes a first semiconductor layer made of a polycrystalline semiconductor, and
the second transistor includes a second semiconductor layer made of an oxide semiconductor.

3. The display device according to claim 1 or 2, wherein the plurality of first signal lines includes a high potential power line and a data line.

4. The display device according to claim 3, wherein the first transistor and the second transistor overlap the high potential power line; and/or
wherein the first transistor and the second transistor overlap the data line.

5. The display device according to any preceding claim, further comprising:
a third buffer layer disposed below the first buffer layer and disposed on the substrate and on the plurality of first signal lines; and
a blocking layer disposed on the third buffer layer and disposed to overlap a semiconductor layer of the first transistor.

6. The display device according to any preceding claim, further comprising:
an insulating layer disposed on a gate electrode of the first transistor; and
a metal pattern disposed on the insulating layer,
wherein the metal pattern electrically connects the first transistor disposed on the first buffer layer with the first signal line disposed below the first buffer layer.

7. The display device according to any preceding claim, further comprising:
a plurality of second signal lines disposed above a source electrode and a drain electrode of the second transistor,
wherein one of the plurality of second signal lines is electrically connected to the second transistor.

8. The display device according to claim 7, wherein the plurality of second signal lines includes a scan line, an emission signal line, and an initialization signal line.

9. The display device according to claim 7 or 8, wherein the second signal lines are, in a cross-section view, disposed between a light emitting element included in the sub-pixel and the source electrode and the drain electrode of the second transistor, and
wherein the light emitting element is electrically connected to the source electrode or the drain electrode of the second transistor via the second signal lines.

10. The display device according to any preceding claim, wherein a source electrode of the first transistor overlaps the first signal line.

11. The display device according to claim 10, further comprising:
a first insulating layer disposed on a gate electrode of the first transistor; and
a second insulating layer disposed, in a cross-section view, between the gate electrode and a first active layer of the first transistor,
wherein the source electrode of the first transistor is connected to both of the first signal line and the first active layer of the first transistor via a first contact hole that penetrates through the first buffer layer, the first insulating layer and the second insulating layer.

12. The display device according to claim 11, wherein the source electrode of the first transistor extends along a side surface of the first contact hole to a lower portion of the first contact hole so that a lower surface of the source electrode of the first transistor is in contact with the first signal line,
wherein a part of the first active layer of the first transistor protrudes from a side surface of the first contact hole towards an interior region of the first contact hole and is covered by and in side contact with the source electrode of the first transistor; and
wherein the source electrode of the first transistor is disposed to contact with an upper surface, a side surface and a lower surface of the part of the first active layer of the first transistor protruding from the side surface of the first contact hole.

13. The display device according to any preceding claim, wherein one of a source electrode and a drain electrode of the second transistor overlaps one of the source electrode and the drain electrode of the first transistor.

14. The display device according to claim 13, further comprising:
a third insulating layer disposed on a gate electrode of the second transistor; and
a fourth insulating layer disposed, in a cross-section view, between the gate electrode and a second active layer of the second transistor,
wherein the one of the source electrode and the drain electrode of the second transistor is connected to both of (i) the one of the source electrode and the drain electrode of the first transistor and (ii) the second active layer of the second transistor via a second contact hole that penetrates through the second buffer layer, the third insulating layer, and the fourth insulating layer.

15. The display device according to claim 14, wherein the one of the source electrode and the drain electrode of the second transistor extends uninterrupted along a side surface of the second contact hole to a lower portion of the second contact hole so that a lower surface thereof is in contact with the one of the source electrode and the drain electrode of the first transistor, and
a part of the second active layer of the second transistor protrudes from a side surface of the second contact hole towards an interior region of the second contact hole, and is covered by and in side contact with the one of the source electrode and the drain electrode of the second transistor.
